# EUROPEAN PATENT APPLICATION

(11) **EP 3 438 615 A1**
(43) Date of publication of application: **06.02.2019**
(21) Application number: 18186462.0
(22) Date of filing: 31.07.2018
(51) Int. Cl.: G01D 4/02, G01R 22/06, G01D 4/00

(54) **COMMUNICATION MODULE FOR SOCKET-TYPE ELECTRICITY METER**

(30) Priority: 31.07.2017 TR 201711172
(71) Applicant: Makel Elektrik Malzemeleri Sanayi Ve Ticaret Anonim Sirketi, Istanbul (TR)
(72) Inventor: AKSU, ERKIN, ISTANBUL (TR)
(74) Representative: Sevinç, Cenk

(57) **Abstract**

The invention relates to an electricity meter structure which comprises a communication module (2) adapted to be connected to the main body (1) of an electricity meter such that its module socket (5) fits into a socket (6) of the electricity meter, and which enables electricity consumption data measured by the electricity meter to be transmitted to a reading center in a wired or wireless way.

## Description

### Technical Field of the Invention:

The present invention relates to a novel communication module that enables standard electricity meters used nowadays to transmit data they read in a wired or wireless way to reading center and that can fittingly be mounted on connection socket located on electricity meters.

### State of the Art:

In all places connected to electric network, an electricity meter measuring the electricity consumption of the place in question is used. The currently used electricity meters are structures which basically feature same properties and have structural and schematic differences. Their main purpose of use is to determine the electricity consumption amount of the place they are connected. The electricity meters of the present art are structures having certain basic features that are standardized and having slight schematic differences.

Data, that result by measuring process of consumed electricity performed by currently used electricity meter structures, are transmitted to electric network reading center basically in two different ways. The most common method of said data transmission is physically reading electricity meters via various reading means by a person who, authorized by reading center, visits each electricity meter in certain time periods. However, as a result of advancements in technology, that reading method is replaced by remote reading method day by day.

Said remote reading method is performed via a remote communication device included in electricity meter. By means of the said remote communication device, necessity of coming nearby the electricity meter to be able to read consumption data measured by the electricity meter is eliminated and measuring data can be transmitted to reading center faster. Hence, reading process of electricity consumption measuring data can be performed from a single center, faster and more coordinately.

In the state of the art, some methods are used about how to include the remote communication devices enabling the process of said remote reading to the electricity meter structure. Body of the electricity meter measuring electricity consumption of the place it is connected is sealed by authorized persons in order to be closed against outer actions. Therefore, inside of the main body of the electricity meter cannot be interfered from outside. Within the state of the art, the most common method preferred for connecting the communication module enabling the remote communication to the electricity meter is that the communication module is located to a place outside the electricity meter and connected to it via a cable. By this means, the seal placed on the main body of the electricity meter does not require any interference.

Locating the remote communication module outside of the electricity meter is an advantageous method in terms of the fact that is eliminates the necessity for interfering the main body of the electricity meter. Furthermore, in cases such as breakdown of the communication module, it is possible to change only the communication module that is broken down without any interference to the electricity meter again. Although these features provide advantages for user by means of the fact that the communication module is located outside of the main body of the meter, the fact that the communication module is outside of the meter also brings along some disadvantages. The communication module located to the main body of the electricity meter independently causes serious security flaw. The communication module used in that way is in position open to external interferences. Therefore, there are risks such as physically interfering to the communication module, shutting down the module or intendedly breaking it down. These situations prevent the electricity meter to be properly remotely read.

Another problem encountered in cases where the communication module is located outside of the electricity meter main body is cable complexity occurred due to cables providing the connections. When the cables allowing the communication module to be in connection with the electricity meter hang out, this leads both to an undesired look and to usage problems for the users. Furthermore, security problems occur for the connection between the electricity meter and the communication unit since the cables in question are open to external interferences.

In the present art, second method used in order that remote communication apparatus for reading data of the electricity meters is included in the meter structure is that the communication module is directly physically located inside the main body of the electricity meter. The electricity meters for which this method is preferred are manufactured such that they comprise one communication module inside their main body inner structure during production stage. Security problems do not occur during usage both for the electricity meter and the communication module since the main body is sealed. However, at this point another problem comes into being and when the communication module is broken down in time the electricity meter has to be interfered. The seal on the main body of the meter should be broken for repairment or replacement of the module. Moreover, in these cases, the electricity meter usually should be replaced completely for the replacement of the communication module. Therefore, in the present art, applications by which the communication module is located inside the main body of the electricity meter are not adequately feasible

Another method used within the scope of the state of the art is that creating a communication module space that enables interference to the main body of the electricity meter from outside. In that method, the electricity meters are manufactured such that there is a space in which the communication modules can be located on the outer surface of the main body and that there is a sealable cover structure for said space. Hence, the communication modules are located in those specific areas reserved for themselves and protected by a sealed cover. However, for the application in question, dimensions of the main body of the meter should be majorly increased, otherwise communication modules cannot be located to the spaces formed for them. Therefore, this causes dimensions of the electricity meters to be exceedingly bigger and leads to more impractical electricity meter structures.

### Aim of the Invention:

Aim of the invention is to provide a novel communication module that enables remote reading of electricity meters.

Another aim of the invention is to provide a novel communication module that are used by being directly fitted on sockets located on the electricity meters.

A further aim of the invention is to eliminate security problems encountered on the communication modules used together with the electricity meters.

A further object of the invention is to provide a novel communication module that can be wirelessly mounted on the electricity meters.

### Description of the Figures:

Fig. 1 - Perspective View of Unmounted Electricity Meter and Communication Module
FIG. 2 - Communication Module
FIG. 3 - Main Body

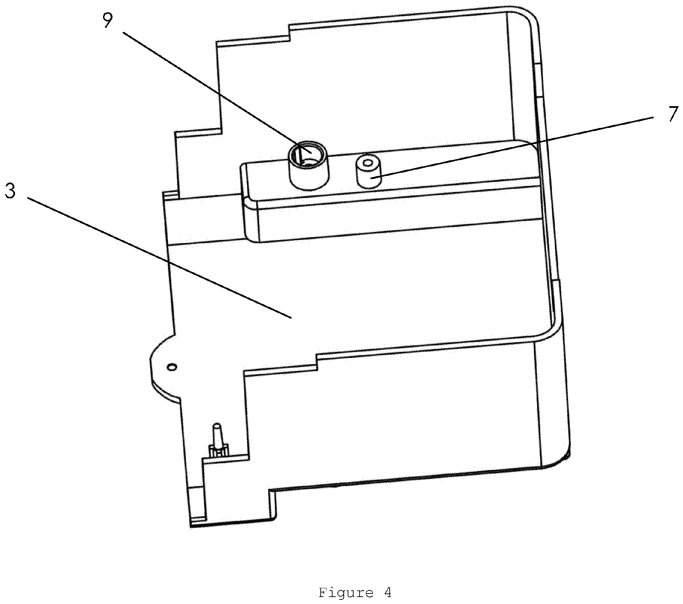

FIG. 4 - Terminal Cover
Fig. 5 - Rear Perspective View of Unmounted Electricity Meter and Communication Module
Fig. 6 - Side Perspective View of Unmounted Electricity Meter and Communication Module

The parts shown in the figures are enumerated individually and names of the parts corresponding to these numbers are as follows:
1. Main Body
2. Communication Module
3. Terminal Cover
4. Thread Flanges
5. Socket of Module
6. Socket of Electricity Meter
7. Thread Housing
8. Mounting Protrusions
9. Mounting Holes

### Description of the Invention:

The invention relates to a novel electricity meters structure having a communication module (2) which enables transmission of electricity consumption data measured by electricity meters to reading center and which is mounted fittingly on a socket of electricity meter (6) located on electricity meters. Said communication module (2) has a structure that is used by being mounted on the main body (1) of the electricity meters.

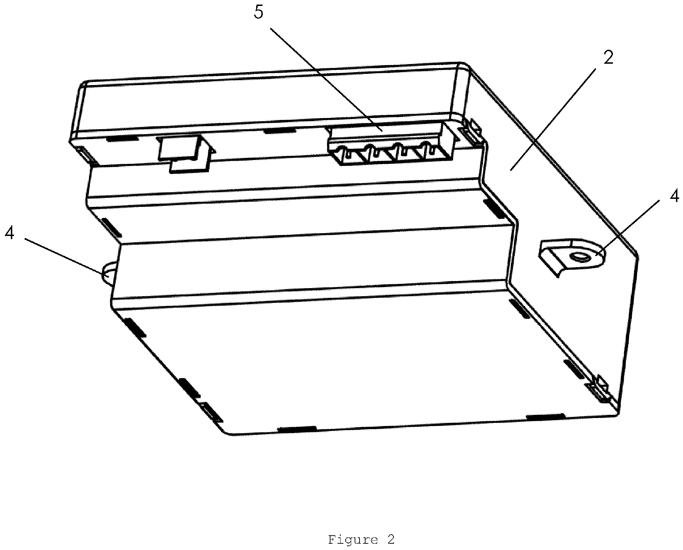

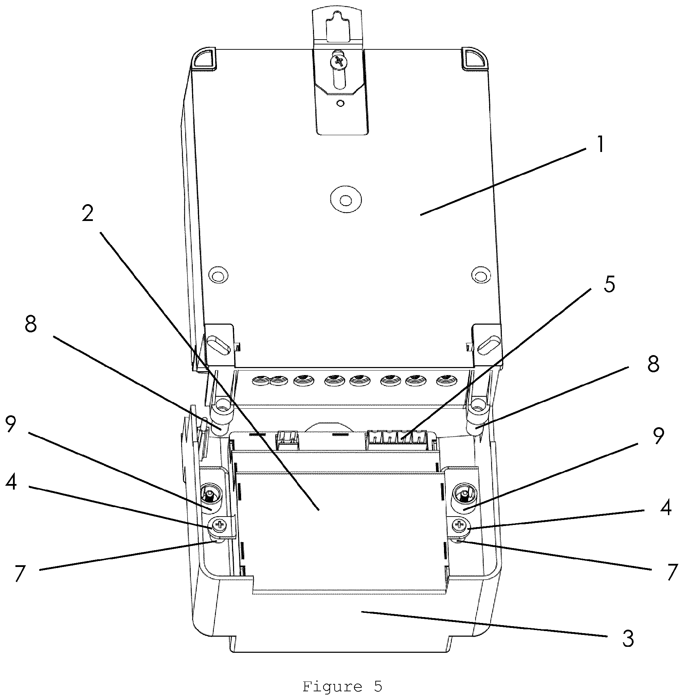

The subject matter communication module (2) is combined with a terminal cover (3) before being mounted on the main body (1) of the electricity meters. Said terminal cover (3) is structure that fits on the communication module (2) and protects the communication module (2) against external factors. Asa can be seen in Figures 2 and 5, the communication module (2) has thread flanges (4) that are mutually located on both side edges thereof. The communication module (2) is mounted to inner portion of the terminal cover (3) via said thread flanges (4).

There are thread housings (7) on the inner surface of the terminal cover (2) such that they are on positions that fittingly correspond to thread flanges (4) during process of seating the communication module (2) into the terminal cover (3). Mounting process of the communication module (2) and the terminal cover (3) to each other is done by means of the thread flanges (4) that fit one on the top of the other and threads fitted into the thread housings (7). After the communication module (2) is seated inside the terminal cover (3), fixation of the communication module (2) inside the terminal cover (3) is provided by tightening the threads that are seated inside the thread housings (7) through the thread flanges (4).

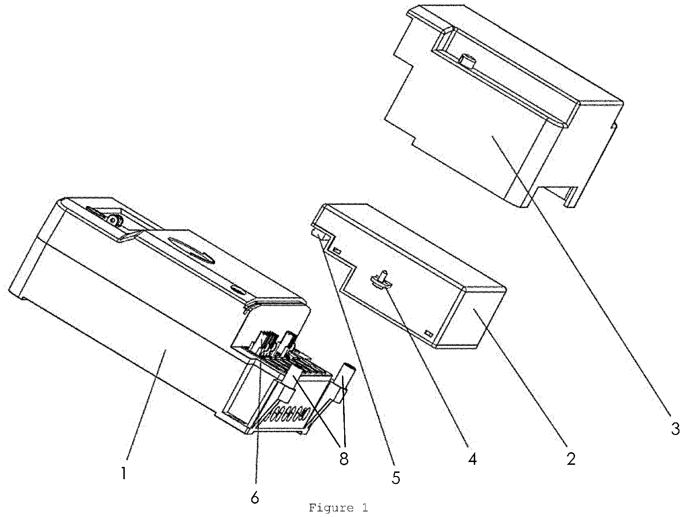

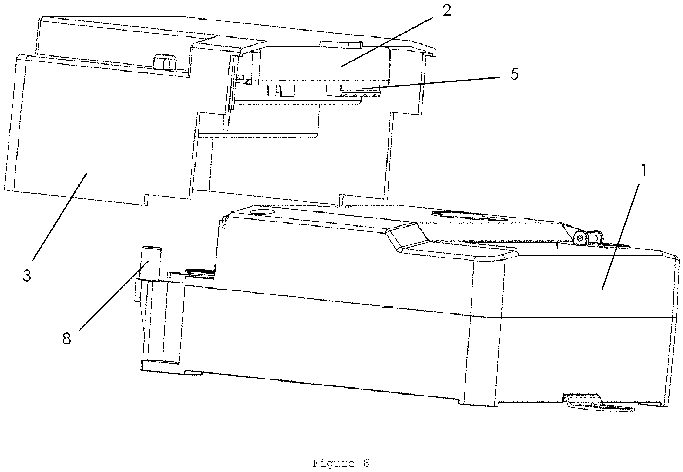

After the communication module (2) is seated inside the terminal cover (3) it needs to be connected to the electricity meter structure. Said connecting process is performed quiet simply by means of physical properties that the subject matter communication module (2) structure and the main body (1) structure have. As can be seen in Figures 1, 5 and 6, the communication module (2) has one socket of module (5) on one side of its surface facing outwardly after being seated inside the terminal cover (3). Said socket of module (5) has a structure that fully fits to socket of electricity meter (6) located on lower side of the main body (1) of the electricity meter. Data exchanging of the electricity meter and the communication module (2) by connecting to each other is performed by the connection of said socket of module (5) and socket of electricity meter (6) to each other.

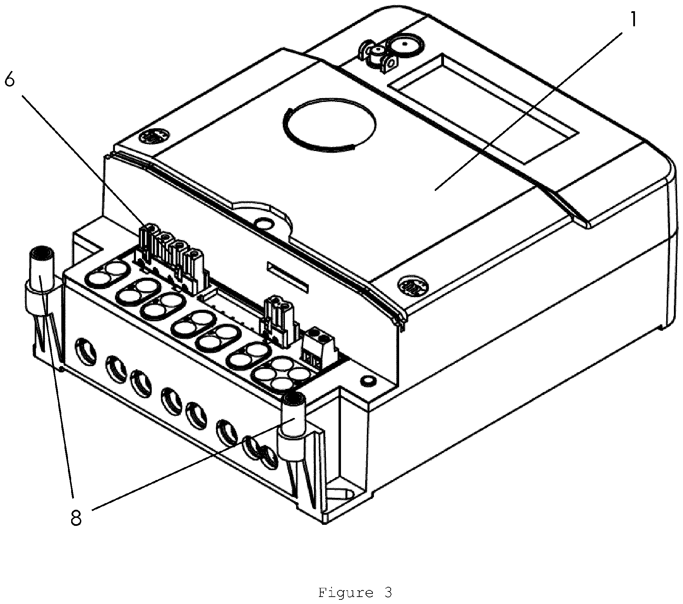

During the connection process of the communication module (2) to the main body (1) via the sockets, the terminal cover (3) is connected to the main body (1) from different points as well. As can be seen in Fig. 3, there are two mounting protrusions (8) in protrusion form which are mutually positioned on corners of lower edges of the main body (1). In inner portion of the terminal cover (3), there are mounting holes (9) which are positioned to be close the thread housings (7) such that they correspond right on the mounting protrusions in a symmetrical position to each other. During the mounting process of the terminal cover (3), in which the communication module (2) is seated, on the main body (1), while the socket of module (5) and the socket of electricity meter (6) is connected to each other on the one hand, the mounting protrusions (8) are seated into the mounting holes (9) on the other hand. Hence, above-mentioned connection process is performed as two separate connection which are the connection of the communication module (2) to the main body (1) and the connection of the terminal cover (3) to the main body (1). A strong connection is provided by means of the fact that the mounting process is done by more than two different points at the same time.

After the mounting, since the terminal cover (3) is sealed by the official authorities of the electricity distribution company there will not be any possibility for users to interfere in the communication module (2) in any manner. Thereby, high-end security for the communication module (2) is provided and the communication module (2) is effectively protected.

The communication module (2) is included to the electricity meter structure together with the terminal cover (3) in which it is located like an extension of the main body (1) by means of being seated on the main body (1) of the electricity meter through the socket connection. By this means, the communication module (2) seem to be a part of the electricity meter. Thereby, an electricity meter structure comprising a communication module (2) in its structure is achieved without substantially changing dimensions of the electricity meter.

While the communication module (2) is directly mounted on the electricity meter structure by seating the connection socket (5) on the socket of electricity meter (6) there will not be any cable connection. This completely eliminates the problems of external interference in cable connections between an electricity meter and a communication module (2). Furthermore, data stream between the communication module (2) and the electricity meter is much more properly provided due to socket type connection. Also, by means of the socket connection used, a significant mountability compared to wired connections is provided and problems such as cable complication are eliminated.

By means of the subject matter communication module (2) and its connection type, the electricity meters are not required to be manufactured such that they comprise a communication module (2) in their structures. Hence, the main bodies (1) of the electricity meters can be designed smaller without comprising the communication module (2). Thereby, the electricity meters take smaller spaces. Furthermore, the problems such as completely replacing the electricity meters manufactured such that they include communication module (2) in their structure because of the fact that the communication modules (2) included in their structure break down in time are also eliminated. If the communication module (2) goes out of order, replacing of the communication module (2) is possible by only breaking the seal of terminal cover (3) by means of the subject matter communication module (2) structure without touching the main body (1) of the electricity meter and its seal. Hence, there is no need to interfere in the main body (1) of the electricity meter in malfunctions regarding the communication module (2).

## Claims

1. The invention is a novel electricity meter structure by which electricity consumption data measured by it can be transmitted in a wired or wireless way to a reading center, **characterized by** comprising the following components;
a **main body (1)** which is main portion, performing measuring process, of an electricity meter; which has two *mounting protrusions (8)* that are mutually positioned on ends of lower edge on a lower edge of its body; which comprise a socket of electricity meter (6) that is positioned on a point right above the mounting protrusions (8) on the lower edge of its body; a **terminal cover (3)** which enables the electricity meter structure to closed against external interferences by being mounted on the lower portion, where the socket of electricity meter (6) is located, of the main body (1); which comprises two *mounting holes (9)* that are mutually positioned according to each other on its inner surface and that allow the terminal cover (3) to be mounted on the main body (1) by being seated on the mounting protrusions (8) on the main body (1); and which comprises two *thread housings (7)* that are mutually positioned according to each other in its inner surface and that help fixation of a communication module (2) located therein; a **communication module (2)** which comprises two *thread flanges (4)* that are mutually positioned on its two side surfaces, and fit on the thread housings (7) in inner surface of the terminal cover (3) during mounting and that enable the communication module (2) to be positioned inside the terminal cover (3) by being mounted on the thread housings (7) via threads located in them; which comprises a *socket of module (5)* that is seated on the socket of electricity meter (6) located on the lower edge of the main body (1) when being mounted on the main body (1) together with the terminal cover (3) in which it is placed and that enables data exchange between the communication module (2) and the main body (1).
